# EUROPEAN PATENT SPECIFICATION

(11) **EP 4 360 124 B1**
(45) Date of publication and mention of the grant of the patent: **23.09.2026**
(21) Application number: 22738397.3
(22) Date of filing: 22.06.2022
(51) Int. Cl.: H10P 72/76, H10P 72/78

(54) **DEVICE FOR HOLDING A WAFER-SHAPED ARTICLE**
VORRICHTUNG ZUM HALTEN EINES SCHEIBENFÖRMIGEN ARTIKELS
DISPOSITIF DE MAINTIEN D'UN ARTICLE EN FORME DE TRANCHE

(30) Priority: 24.06.2021 GB 202109051
(43) Date of publication of application: 01.05.2024
(73) Proprietor: Lam Research AG, 9500 Villach (AT)
(72) Inventor: BRUGGER, Michael, 9500 Villach (AT); PUGGL, Michael, 9500 Villach (AT); SEMMELROCK, Christoph, 9500 Villach (AT)
(74) Representative: Mewburn Ellis LLP
(86) International application number: PCT/EP2022/067050
(87) International publication number: WO 2022/268897

(56) References cited:
- DE-C2- 4 092 221
- US-A1- 2011 151 675
- US-A1- 2013 127 102
- US-A1- 2018 040 502

## Description

### Field of the invention

The present invention relates to a device for holding a wafer-shaped article, for example a semiconductor wafer, typically while the wafer-shaped article is being processed.

### Background of the invention

Wafers such as semiconductor wafers may be subjected to various surface treatment processes, such as etching, cleaning, polishing and material deposition. A wafer is typically held using a chuck while undergoing such surface treatment processes.

At least some of these surface treatment processes involve applying a liquid to a surface of the wafer. For example, the surface of the wafer may be etched by applying a processing liquid such as hydrofluoric acid to selected locations on the surface of the wafer. Alternatively, the surface of the wafer may be cleaned by applying a cleaning liquid or rinse liquid such as isopropyl alcohol or de-ionised water to the surface of the wafer.

The wafer may be spun when the liquid is applied to the surface of the wafer, for example using a rotatable chuck, to assist distribution of the liquid over the surface of the wafer. Where the liquid is a cleaning liquid or a rinse liquid, such a process may be referred to as a spin-clean process.

In addition, the surface of the wafer may subsequently be dried by heating the wafer to cause evaporation of the liquid on the surface of the wafer, for example by using heating elements such as LEDs in the chuck to heat an underside of the wafer.

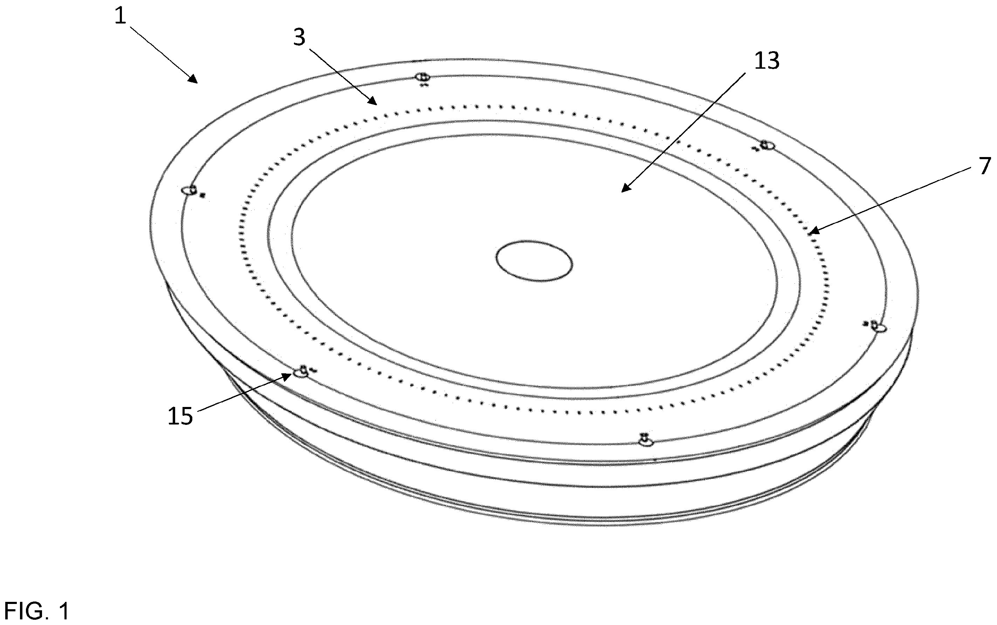

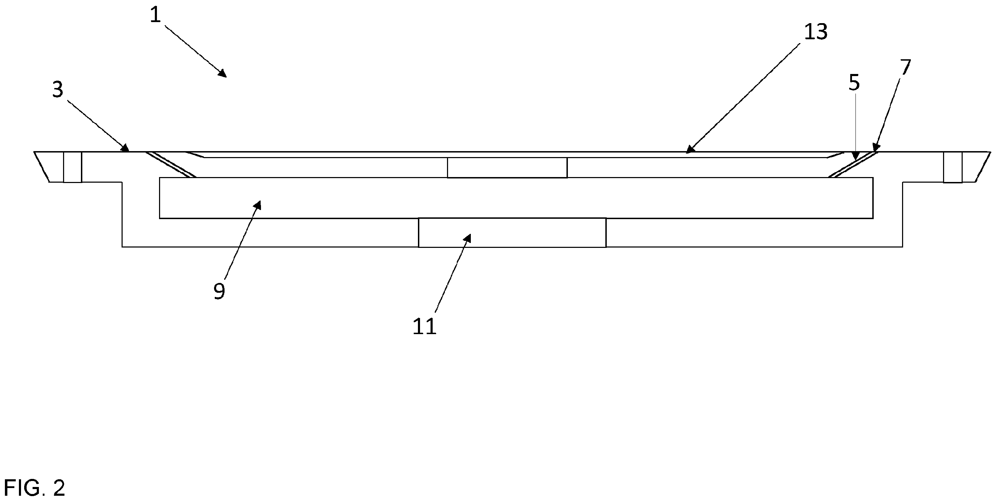

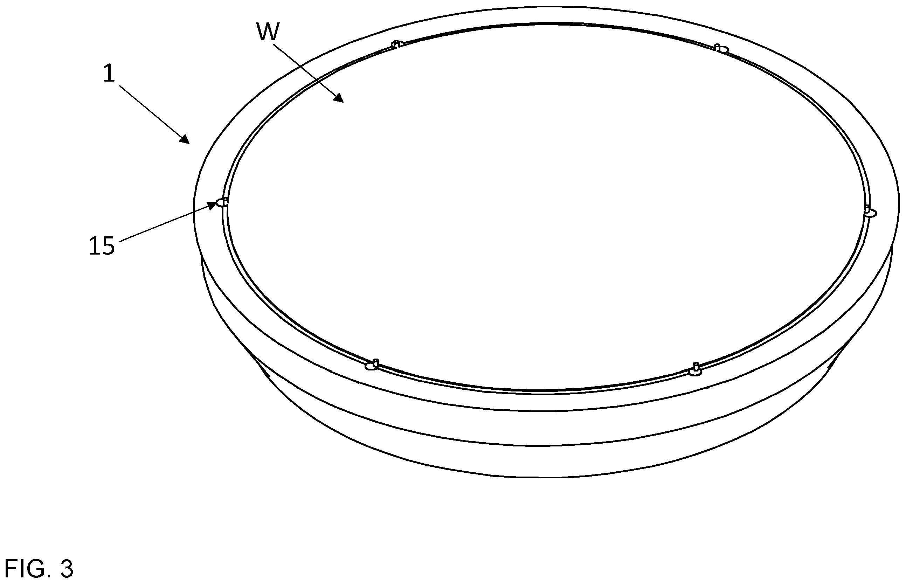

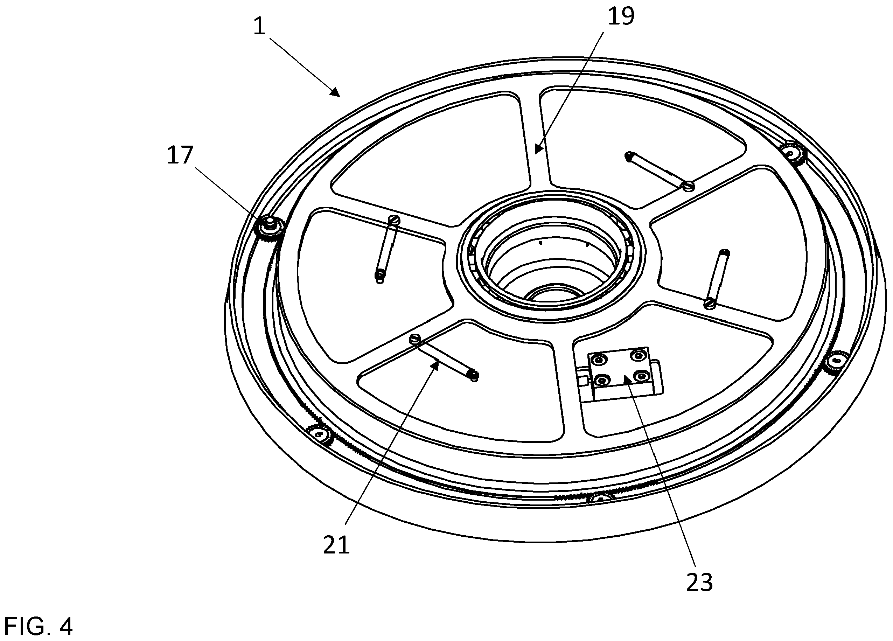

FIGS. 1 to 4 show a device 1 for holding a wafer-shaped article that has previously been used by the applicant. Specifically, FIG. 1 is a top perspective view of the device 1, FIG. 2 is a simplified cross-sectional view of the device 1, FIG. 3 is a top perspective view of the device 1 with a wafer-shaped article held by the device, and FIG. 4 is a bottom perspective view of the device 1.

The device 1 is a chuck that supports and grips a wafer W, such as a semiconductor wafer W, while the wafer W is being processed.

Specifically, as discussed below, the device 1 supports the wafer W on a gas cushion, while preventing lateral displacement of the wafer W relative to the device 1.

As illustrated in FIGS. 1 and 2, the device 1 has a top surface 3 that faces a wafer W being supported by the device 1.

Furthermore, the device 1 comprises a plurality of gas nozzles 5 in the device 1 having outlets 7 in the top surface 3 of the device 1. The gas nozzles 5 are all connected to a gas distribution chamber 9 within the device 1. Therefore, gas supplied to the gas distribution chamber 9 is dispensed through the gas nozzles 5 to the top surface 3 of the device 1 from the outlets 7.

Gas is supplied to the gas distribution chamber 9 through an opening 11 in a bottom surface of the device 1 that leads to the gas distribution chamber 9. For example, a shaft having a channel or passageway for supplying the gas may be inserted into the opening 11. The gas is a compressed gas, typically Nitrogen.

As shown in FIG. 1, the outlets 7 of the gas nozzles 5 are arranged on the top surface 3 of the device 1 in a circular arrangement around a centre of the top surface 3.

Furthermore, the outlets 7 of the gas nozzles 5 are all arranged in a peripheral zone or region of the top surface 3 of the device. The outlets 7 of the gas nozzles 5 are all closer to a periphery of the top surface 3 than a centre of the top surface 3.

Furthermore, as illustrated in FIG. 2, each of the gas nozzles 5 is angled outwards away from a central axis of the device 1. In other words, the gas nozzles 5 are angled radially outwards. Specifically, each of the gas nozzles 5 is angled so that the gas exits the outlet 7 at an acute angle to the top surface 3 of the device 1.

The outlets 7 of the gas nozzles 5 are arranged on the top surface 3 so as to be covered by a peripheral zone or region of the wafer W when the wafer W is positioned on the top surface 3 of the device 1 and supported by the device 1.

This configuration of the gas nozzles 5 and outlets 7 means that when a wafer W is positioned on the top surface 3 of the device 1, and a compressed gas such as Nitrogen gas is supplied through the gas nozzles 5 out of the outlets 7, the wafer W is held in a freely floating fashion above the top surface 3 in a state of equilibrium on account of the vacuum or low pressure produced beneath the wafer W by the gas exiting from the outlets 7 due to Bernoulli's principle.

The wafer W is therefore held in a freely floating fashion above the top surface 3 of the device 1 supported on a gas cushion and does not come into physical contact with the top surface 3 of the device 1.

As illustrated in FIGS. 1 and 2, the top surface 3 of the device has a central recessed portion 13 in which the top surface 3 is recessed (set back) relative to the surrounding top surface 3. Specifically, the recessed portion 13 is circular in shape and is centred on a centre of the top surface 3.

A spacing between the top surface 3 and the wafer W is greater in the recessed portion 13 than outside the recessed portion 13 on the top surface 3.

The outlets 7 of the gas nozzles 5 are provided outside the central recessed portion 13, in a peripheral zone or region of the top surface 3.

The purpose of the recessed portion 13 is to reduce or prevent contact between the wafer W and the top surface 3 of the device 1, which may otherwise be caused by deformation of the wafer W by the vacuum or low pressure produced below the wafer W by the flow of gas from the outlets 7. In particular, in the recessed portion 13 a distance between the top surface 3 and the wafer W is increased relative to outside the recessed portion 13. Therefore, if the wafer W is deformed by the vacuum or low pressure below the wafer W, the wafer W is less likely to come into contact with the top surface 3 of the device 1 in the recessed portion 13.

To prevent lateral movement of the wafer W relative to the top surface 3 of the device 1 while the wafer W is supported by the gas cushion, a circular series of rotatable gripping pin assemblies 15 are provided in the device 1 so as to surround a peripheral edge of the wafer W positioned on the top surface 3. The rotatable gripping pin assemblies 15 are rotatable to grip the peripheral edge of the wafer W, to prevent lateral movement of the wafer W relative to the top surface 3.

Specifically, as illustrated in FIGS. 1 and 3, each of the plurality of rotatable gripping pin assemblies 15 has an eccentric (off-centre relative to a longitudinal axis of the gripping pin assembly 15) protrusion that protrudes from a top of the rotatable gripping pin assembly 15 above the top surface 3 of the device 1. Rotation of the rotatable gripping pin assembly 15 around its longitudinal axis causes the eccentric protrusion to move closer to, or further away from, the centre of the top surface 3. Therefore, by rotating the plurality of rotatable gripping pin assemblies 15 in synchronisation, the rotatable gripping pin assemblies 15 can be caused to grip the peripheral edge of the wafer W to prevent lateral movement of the wafer W relative to the top surface 3. As discussed in more detail below, the rotatable gripping pin assemblies 15 each comprise a gear that is meshed with a common ring gear provided in the device, such that rotation of the ring gear causes simultaneous rotation of each of the rotatable gripping pin assemblies 15.

The rotatable gripping pin assemblies 15 are located in the peripheral zone or region of the top surface 3, radially outwards of the outlets 7 of the gas nozzles 5.

The gas nozzles 5 are therefore positioned in the peripheral zone or region of the top surface 3 between the rotatable gripping pin assemblies 15 and the recessed portion 13, such that the outlets 7 are covered by the peripheral zone or region of the wafer W when the wafer W is supported by the device 1.

FIG. 4 is a bottom perspective view of the device 1, showing the mechanism for rotating the rotatable gripping pin assemblies 15.

As illustrated in FIG. 4, each of the rotatable gripping pin assemblies 15 has a gear 17 at or adjacent to the bottom end thereof (the end opposite to the eccentric protrusion). Each of the gears 17 of the rotatable gripping pin assemblies 15 are meshed (engaged) with a common ring gear 19 in the device. The ring gear 19 is rotatable, for example by an electric motor, so as to cause simultaneous rotation of the gears 17 of the rotatable gripping pin assemblies 15 and therefore simultaneous rotation of the rotatable gripping pin assemblies 15.

As illustrated in FIG. 4, the ring gear 19 is coupled to a body of the device 1 via a plurality of springs 21, for example coil springs. For example, each of the springs 21 is connected at one end to the ring gear 19 and at the other end to the body of the device 1, for example using connectors such as pins, screws or bolts. The springs 21 bias the ring gear 19 to urge the ring gear 19 to rotate to a position at which the rotatable gripping pin assemblies 15 clamp the peripheral edge of the wafer W. For example, the springs 21 may urge ring gear 19 to rotate to a rotational position at which the eccentric protrusions of the rotatable gripping pin assemblies 15 are at their closest position to the centre of the top surface 3 (most radially inwards position).

In this example, the ring gear 19 has spokes and the springs 21 are connected to the spokes of the ring gear 19.

When a wafer W is being positioned on the top surface 3 of the device 1, the ring gear 19 may first be forcibly rotated against the biasing force of the springs 21 to a rotational position at which the rotatable gripping pin assemblies 15 will not clamp the peripheral edge of the wafer W (for example the eccentric protrusions of the rotatable gripping pin assemblies 15 are at the furthest position from the centre of the top surface 3). The ring gear 19 may be forcibly rotated against the biasing force of the springs 21 by a motor, for example.

Then, when the wafer W is positioned on the top surface 3 and supported by the cushion of gas from the outlets 7, the force applied to rotate the ring gear 19 against the biasing force of the springs 21 may be released, so that the biasing force of the springs 21 acts to cause the ring gear 19 to rotate, so that the rotatable gripping pin assemblies 15 are rotated to grip the peripheral edge of the wafer W.

In order to reduce a force applied to the peripheral edge of the wafer W when the rotatable gripping pin assemblies 15 are first brought into contact with the peripheral edge of the wafer W, the device 1 further comprises a damper 23 coupled to the ring gear 19. In particular, the damper 23 is coupled between the ring gear 19 and the body of the device 1.

The damper 23 acts to reduce a force applied to the peripheral edge of the wafer W when the rotatable gripping pin assemblies 15 are first brought into contact with the peripheral edge of the wafer W. For example, the damper 23 may comprise a rod that is connected to the ring gear 19, or arranged to contact the ring gear 19, and that is biased towards the ring gear 19. Alternatively, the damper 23 may be a dashpot type damper that is coupled between the ring gear 19 and body of the device 1.

US2011/151675A1 discloses that a spin chuck in an apparatus for single wafer wet processing has structures at its periphery that, in combination with a supported wafer, form a series of annular nozzles that direct flowing gas from a chuck-facing surface of the wafer, around the edge of the wafer, and exhaust the gas away from the non-chuck-facing surface of the wafer, thereby preventing treatment fluid applied to the non-chuck-facing surface from contacting the edge region of the wafer. Retaining pins with enlarged heads engage the wafer edge and prevent it from being displaced upwardly when a high flow rate of gas is utilized.

US2018/040502A1 discloses an apparatus for processing wafer-shaped articles that comprises a rotary chuck having a series of contact elements surrounding a wafer-shaped article when mounted on the rotary chuck. A non-rotating plate is positioned interiorly of the series of contact elements. The plate includes a gas supply that is configured to supply gas so as to support a wafer-shaped article without contacting the non-rotating plate according to the Bernoulli principle.

### Summary of the invention

The present inventors have realised that in some circumstances damage or contamination may occur to the wafer W when using the existing device 1 described above, particularly when the device 1 is used to hold thin wafers that have lower strength and/or rigidity.

In particular, when a thin wafer is supported by the device 1, the present inventors have realised that the low pressure or vacuum below the wafer can cause sufficient deformation of the wafer to bring the wafer into contact with the top surface 3 of the device 1 in the recessed portion 13. This can cause contamination of the wafer, for example by the wafer picking up particles from the top surface of the device 1.

In addition, or alternatively, with a thin wafer the wafer can be damaged or broken when the rotatable gripping pin assemblies 15 are first brought into contact with the peripheral edge of the wafer.

The present invention may address one or more of these problems.

At its most general, a first aspect of the present invention relates to reducing the low pressure or vacuum beneath the wafer by providing one or more gas nozzles having outlets in the recessed portion of the top surface. By supplying some gas to the recessed portion, the low pressure or vacuum in the recessed portion can be reduced. Therefore, deformation of the wafer due to the low pressure or vacuum can be reduced or prevented.

According to a first aspect of the present invention there is provided a device for holding a wafer-shaped article, the device having a device body comprising:
a surface configured to face a wafer-shaped article supported by the device, the surface having a central recessed portion;
first gas nozzles having outlets in the surface outside the central recessed portion; and
second gas nozzles having outlets in the surface inside the central recessed portion.

Therefore, in the present invention second gas nozzles are provided that have outlets in the surface inside the recessed portion. Gas supplied to the recessed portion via these second gas nozzles reduces a low pressure or vacuum beneath the wafer-shaped article caused by the gas supplied via the first gas nozzles having outlets in the surface outside the central recessed portion (the vacuum or low pressure being caused due to Bernoulli's principle).

Therefore, deformation of the wafer-shaped article due to the low pressure or vacuum may be prevented or reduced, and contamination of the wafer-shaped article due to contact with the surface of the device may therefore be prevented or reduced.

The first aspect of the present invention may have any one, or, where compatible, any combination of the following optional features.

The device may be a chuck.

The device may be a spin chuck.

The wafer-shaped article may be a wafer such as a semiconductor wafer.

The surface configured to face the wafer-shaped article may be a top surface of the device.

The surface may be circular.

The recessed portion may be circular.

A chamfered or angled edge or portion may be provided at the outer periphery of the recessed portion.

The recessed portion being central may mean that the recessed portion includes a centre of the surface, and/or that the recessed portion is centred on the centre of the surface.

The term recessed portion means an area or region of the surface where the surface is recessed or set back relative to another area of the surface. In the recessed portion, a distance or spacing between the surface and a wafer supported by the device is greater than outside the recessed portion.

A gas nozzle may mean a gas flow path, or gas passageway, or gas tube, or gas channel, or bore hole.

An outlet may mean an opening or a hole in the surface.

In the first aspect of the present invention, each of the second gas nozzles is perpendicular to the surface, or substantially perpendicular to the surface.

Each of the first gas nozzles may be angled outwards relative to the perpendicular to the surface. For example, each of the first gas nozzles may be angled so that gas exiting the outlet is at an acute angle to the surface. Each of the first gas nozzles may be angled radially outwards.

The outlets of the first gas nozzles may be arranged in a peripheral zone or region of the surface, for example in an annular peripheral zone or region of the surface.

The outlets of the first gas nozzles may be arranged on the surface so as to be covered by a peripheral zone or region of the wafer when the wafer is positioned on the surface.

The outlets of the first gas nozzles may all be closer to a periphery of the surface than a centre of the surface.

The outlets of the first gas nozzles may have a diameter of 0.4 mm or more to 2.0 mm or less, for example. The outlets of the first gas nozzles may have a diameter of 0.8 mm in one specific example.

The device may comprise a transparent window in the recessed portion, and the second gas nozzles may include one or more gas nozzles in the transparent window.

For example, the transparent window may be centred on a centre of the surface.

The transparent window may be circular.

The transparent window may be made of transparent polymer, or glass, for example silica glass or sapphire glass.

The device may include a gas distribution chamber in the device body, the gas distribution chamber being connected to the first gas nozzles and the second gas nozzles. Therefore, gas supplied to the gas distribution chamber is supplied to the first and second gas nozzles.

Compressed Nitrogen gas may be supplied to the gas distribution chamber.

The gas distribution chamber may be an enclosed space or volume within the device.

Gas may be supplied to the gas distribution chamber via a shaft inserted into the gas distribution chamber via an opening in the device body, wherein the shaft has a channel for suppling the gas along the shaft to the gas distribution chamber.

A number of the first gas nozzles may be greater than a number of the second gas nozzles. For example, a number of the first gas nozzles may be more than twice a number of the second gas nozzles, or more than three times a number of the second gas nozzles.

The recessed portion may have a depth of 0.3 mm or more to 2 mm or less. The depth of the recessed portion may be measured relative to the surface surrounding the recessed portion.

The recessed portion may be circular and may have a diameter of 210 mm or more to 250 mm or less.

At least some of the outlets of the first gas nozzles may be arranged in a circular pattern.

All of the outlets of the first gas nozzles may be arranged in a circular pattern.

The circular pattern may be centred on a centre of the surface.

At least some of the outlets of the second gas nozzles may be arranged in a circular pattern. The circular pattern may be centred on a centre of the recessed portion and/or a centre of the surface.

The second gas nozzles may have a diameter between 0.4 mm inclusive to 2.0 mm inclusive, for example the second gas nozzles may have a diameter of 0.9 mm.

Where one or more second gas nozzles are provided in the transparent window, the one or more second gas nozzles in the transparent window may have a larger diameter than any second gas nozzles outside the transparent window.

In one specific example, the one or more second gas nozzles in the transparent window may have a diameter of 1.5 mm.

The device may comprise a plurality of gripping pin assemblies adapted and positioned relative to the device body for gripping the wafer-shaped article, wherein each of the gripping pin assemblies is rotatable between a gripping configuration in which the gripping pin assemblies grip the wafer-shaped article, and a non-gripping configuration in which the gripping pin assemblies do not grip the wafer-shaped article.

The gripping pin assemblies may be configured to contact the periphery of the wafer-shaped article so as to grip the wafer-shaped article between the gripping pin assemblies.

Of course, in other embodiments the gripping pin assemblies may not be provided, and another mechanism for preventing lateral movement of the wafer-shaped article relative to the surface may be provided instead, or no such mechanism may be provided.

The gripping pin assemblies may extend through the surface outside the recessed portion, and the outlets of the first gas nozzles may be located on the surface between the gripping pin assemblies and the recessed portion.

The gripping pin assemblies may be provided in the peripheral zone or region of the surface, radially outwards of the outlets of the first gas nozzles.

The peripheral zone or region of the surface may mean an annular region of the surface that immediately surrounds the central recessed portion of the surface.

The gripping pin assemblies may each have an eccentric (off-centre relative to a longitudinal axis of the gripping pin assembly) protrusion that protrudes from a top of the gripping pin assembly above the surface of the device. Rotation of the gripping pin assembly around its longitudinal axis may therefore cause the eccentric protrusion to move closer to, or further away from, the centre of the surface. Therefore, by rotating the plurality of gripping pin assemblies in synchronisation, the gripping pin assemblies can be caused to grip the peripheral edge of the wafer to prevent lateral movement of the wafer relative to the surface.

Each of the gripping pin assemblies may have a respective gear that is meshed with a common ring gear in the device, so that rotation of the ring gear causes simultaneous rotation of the gripping pin assemblies.

At its most general, a non-claimed example relates to reducing a force with which the wafer-shaped article is impacted by the gripping elements when the wafer-shaped article is first gripped by the gripping elements, by reducing a biasing force by which the gripping elements are biased towards a gripping configuration.

According to the non-claimed example there is provided a device for holding a wafer-shaped article, the device comprising gripping elements adapted to contact a peripheral edge of the wafer-shaped article, the gripping elements being biased towards a closed position by one or resilient members, wherein a position at which each of the one or more resilient members is connected to a device body is adjustable.

Alternatively, according to the non-claimed example there is provided a device for holding a wafer-shaped article, the device comprising gripping elements adapted to contact a peripheral edge of the wafer-shaped article, the gripping elements being biased towards a closed position by one or resilient members, wherein a length of each of the one or more resilient members is adjustable.

Alternatively, according to the non-claimed example there is provided device for holding a wafer-shaped article, the device comprising gripping elements adapted to contact a peripheral edge of the wafer-shaped article, the gripping elements being biased towards a closed position by one or resilient members, wherein a biasing force applied to the gripping elements by the one or more resilient members is adjustable.

Adjusting a position at which each of the one or more resilient members is connected to the device body may change an amount of extension of the resilient member, or a length of the resilient member, and therefore may change a biasing force applied to the gripping elements by the one or more resilient members.

In particular, by adjusting a position at which each of the one or more resilient members is connected to the device body, an amount by which the one or more resilient members bias the gripping elements towards the closed position can be reduced. Therefore, a force with which the gripping elements first contact the wafer-shaped article when the wafer-shaped article is first gripped by the gripping elements can be reduced. This may reduce or prevent damage from occurring to the wafer-shaped article.

The non-claimed example may have any of the features of the first aspect of the present invention discussed above.

The non-claimed example can be combined with the first aspect, or may be independent of the first aspect.

The non-claimed example may have any one, or, where compatible, any combination of the following optional features.

A closed position of the gripping elements means a position at which the gripping elements contact and grip the wafer-shaped article.

A resilient member may mean a resilient part or element, or an elastic member, element or part.

The one or more resilient members may be a spring, for example a coil spring.

There may be a plurality of the resilient members.

The one or more resilient members may be connected to the device body via a removable adaptor.

The removable adaptor may be a removable insert or removable element.

Adjusting the position at which each of the one or more resilient members is connected to the device body may comprise adding or removing the removable adaptor.

The removable adaptor may be connected to the device body at a first position relative to the device body and connected to the resilient member at a second position relative to the device body.

A length of the resilient member when connected to the removable adaptor is less than a length of the resilient member when connected directly to the device body.

A length of the resilient member when connected to the removable adaptor at the second position is less than a length of the resilient member if the resilient member was connected to the device body directly at the first position.

Each of the gripping elements may be rotatable between a gripping configuration in which the gripping elements grip the wafer-shaped article, and a non-gripping configuration in which the gripping elements do not grip the wafer-shaped article.

The device may comprise a first gear that is coupled to the gripping elements to drive rotation of the gripping elements.

Each of the one or more resilient members may be connected to the first gear.

The gripping elements may be rotatable gripping pin assemblies, for example as described above.

Each of the gripping elements may comprise a second gear that is meshed with the first gear.

The device may comprise at least one damping mechanism that controls a force with which the clamping elements impact the peripheral edge of the wafer-shaped article when moving to the closed position. However, it is not necessary for a damping mechanism to be present.

The removable adaptor may be substantially flat, and/or substantially planar.

The removable adaptor may be arranged with a longitudinal axis of the removable adaptor parallel to a main surface of the device body.

The removable adaptor may comprise a first connection element for connecting the removable adaptor to the device body. For example, the device body may comprise a pin, and the first connecting element may comprise an opening, hole or recess for receiving the pin.

The removable adaptor may comprise a second connection element for connecting the removable adaptor to the resilient member. For example, the second connecting element may comprise a pin to which the resilient member can be attached.

Of course, other connecting or fastening means can be used instead of these first and second connecting elements.

The device body may comprise one or more connectors for connecting a resilient member to the device body, for example one or more pins to which a resilient member such as a spring can be connected, and the one or more removable adaptors may be connected to the one or more connectors instead of the resilient member. The resilient member is then instead connected to the removable adaptor, at a different position relative to the device body such that the length of the resilient member is reduced.

According to another aspect of the present invention there is provided a processing apparatus for processing a wafer-shaped article, the processing apparatus comprising the device according to the first aspect described above.

### Brief description of the drawings

Embodiments of the present invention will now be discussed, by way of example only, with reference to the accompanying Figures, in which:
FIG. 1 is top perspective view of a device for holding a wafer-shaped article that has previously been used by the applicant;
FIG. 2 is a simplified cross-sectional view of the device of FIG. 1;
FIG. 3 is a to perspective view of the device of FIG. 1 with a wafer-shaped article held by the device;
FIG. 4 is a bottom perspective view of the device of FIG. 1.
FIG. 5 is a top perspective view of a device for holding a wafer-shaped article according to embodiments of the present invention;
FIG. 6 is a simplified cross-sectional view of the device of FIG. 5;
FIG. 7 is a bottom perspective of the device of FIG. 5.

### Detailed description of the preferred embodiments and further optional features of the invention

Aspects and embodiments of the present invention will now be discussed with reference to the accompanying figures. Further aspects and embodiments will be apparent to those skilled in the art.

All documents mentioned in this text are incorporated herein by reference.

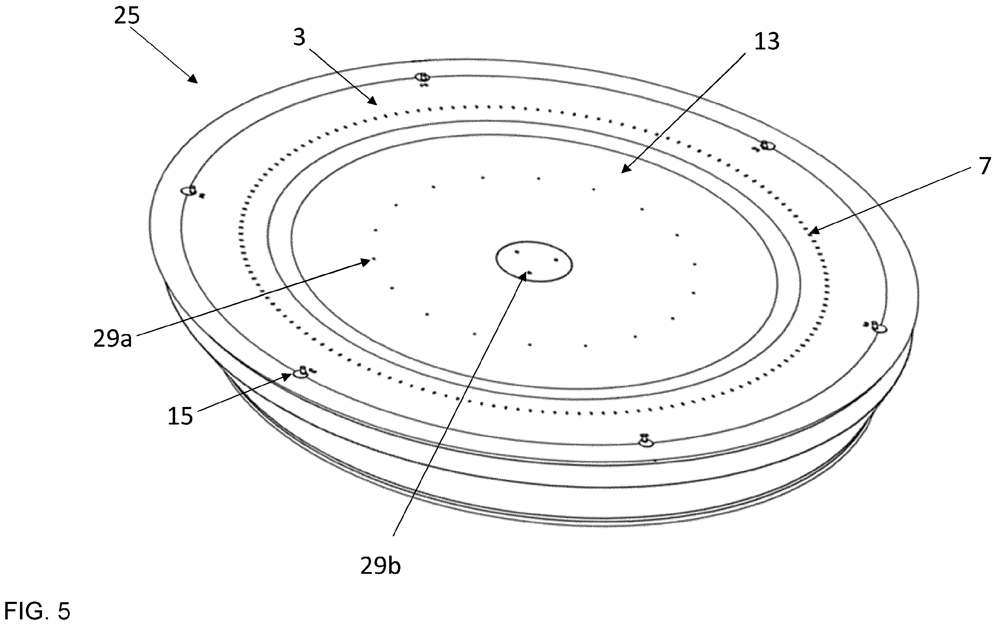

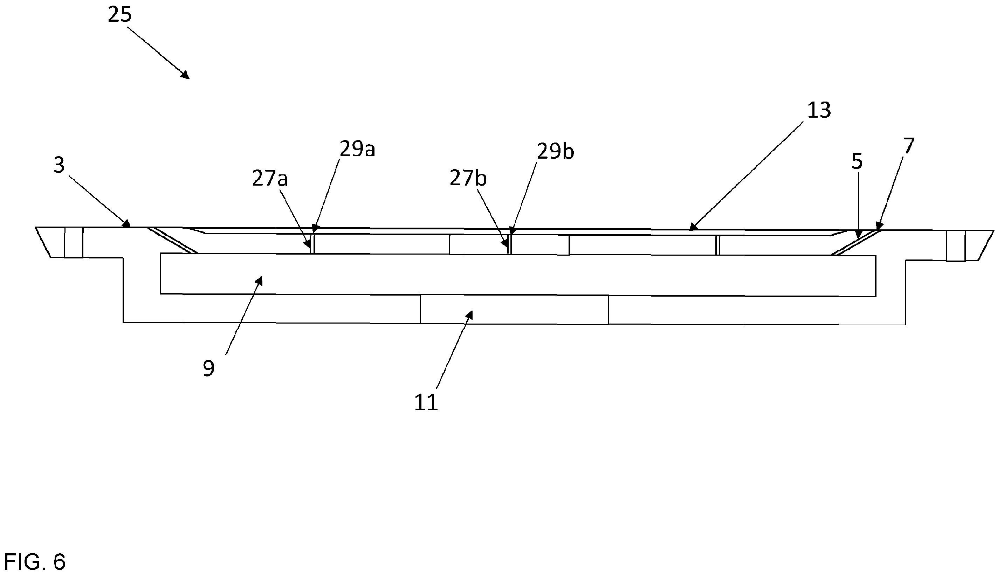

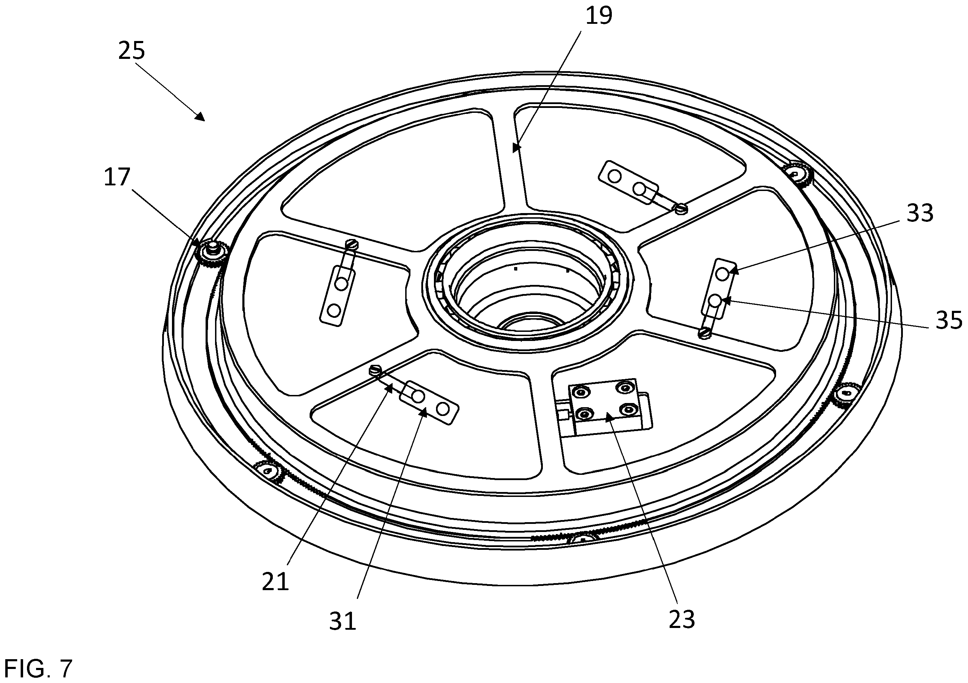

FIGS. 5 to 7 show a device 25 for holding a wafer-shaped article according to an embodiment of the present invention. Specifically, FIG. 5 is a top perspective view of the device 25, FIG. 6 is a simplified cross-sectional view of the device 25, and FIG. 7 is a bottom perspective view of the device 25.

The device 25 may have any one, more than one, or all, of the features of the device 1 described above. For example, some features of the device 25 that correspond to features of the device 1 are indicated using the same reference numbers in FIGS. 5 to 7. Description of these features is not repeated here for conciseness.

The device 25 according to the embodiment of the present invention may be a modified version of the device 1 described above. However, the device 25 does not have to have all the features of the device 1 described above.

As illustrated in FIGS. 5 and 6, in addition to the gas nozzles 5 having outlets 7 in the peripheral zone or region of the top surface 3, in the embodiment of the present invention the device 25 further comprises gas nozzles 27a and 27b having outlets 29a and 29b inside the recessed portion 13 of the top surface 3.

The gas nozzles 27a and 27b in this embodiment include gas nozzles 27a having outlets 29a arranged in a circular arrangement around a centre of the recessed portion 13 (and centre of the top surface 3), and gas nozzles 27b having outlets 29b arranged in a transparent window positioned in a centre of the recessed portion 13.

The gas nozzles 27a and 27b extend perpendicular, or substantially perpendicular, to the top surface 3.

As illustrated in FIG. 6, the gas nozzles 27a and 27b are connected to the gas distribution chamber 9, so that when compressed gas such as compressed Nitrogen gas is supplied to the gas distribution chamber 9, the gas is supplied to both the gas nozzles 5 and the gas nozzles 27a and 27b.

A number of the gas nozzles 27a and 27b is significantly smaller than a number of the gas nozzles 5, for example less than half, or less than a third, of the number of the gas nozzles 5.

Of course, the number, and/or positioning and/or orientation of the gas nozzles 27a and 27b and outlets 29a and 29b in the recessed portion 13 may be different to that illustrated in FIGS. 5 and 6.

For example, in another embodiment gas nozzles 27a and 27b may not be provided in the transparent window, and/or the transparent window may be omitted.

In an alternative embodiment, gas nozzles 27a and 27b may only be provided in the transparent window.

In an alternative embodiment, the gas nozzles 27a may not be arranged in a circular pattern, and/or additional gas nozzles 27a may be provided in addition to a circular pattern.

Furthermore, the number and/or positioning and/or orientation of the gas nozzles 5 and outlets 7 outside the recessed portion 13 may be different to that illustrated in FIGS. 5 and 6. For example, the gas nozzles 5 may not be arranged in a circular pattern.

Furthermore, the position and/or shape of the gas distribution chamber may be different to that illustrated in FIGS. 5 and 6.

Furthermore, a diameter of the recessed portion 13 may be different to that illustrated in FIGS. 5 and 6.

Furthermore, a depth of the recessed portion 13 may be different to that illustrated in FIGS. 5 and 6.

In other embodiments of the present invention, the rotatable gripping pin assemblies 15 may be omitted, or may be replaced with an alternative mechanism for preventing lateral movement of the wafer relative to the top surface 3 of the device 25, for example an alternative form of clamp, or a linearly movable mechanism instead of a rotatable mechanism.

In other embodiments, the transparent window in the centre of the recessed portion may not be present.

The device 25 may be mounted on a shaft for rotating the device 25.

The device 25 may be included in a processing apparatus for processing a wafer held by the device 25. For example, the apparatus may include a liquid dispenser arranged to dispense liquid on a top surface of a wafer held by the device 25.

The device 25 may include one or more heating elements, such as LEDs, for heating a wafer held by the device 25.

FIG. 7 is a bottom perspective view of the device 25 in one embodiment. However, in other embodiments the bottom of the device 25 may be different to that illustrated in FIG. 7. For example, the bottom of the device 25 may instead be as illustrated in FIG. 4.

Furthermore, the bottom perspective view of the device 25 may be combined with the top view illustrated in FIG. 1, for example, rather than the top view illustrated in FIG. 5.

The embodiment illustrated in FIG. 7 differs from the arrangement illustrated in FIG. 4 in that the springs 21 are not directly connected to the device body. Instead, the springs 21 are connected to the device body via removable adaptors 31.

The removable adaptors 31 are each connected to the device body at a first position 33 relative to the device body, and are connected to the spring 21 at a second position 35 relative to the device body. The second position 35 is closer to where the spring 21 is connected to the ring gear 19 than the first position 33.

The length of the spring 21 when connected to the removable adaptor 31 at the second position 35 is less than the length the spring 21 would have if the spring 21 was connected to the device body directly at the first position 33.

The device body may have connectors or fasteners, for example pins, for connecting the springs 21 to the device body. However, in this embodiment the removable adaptors 31 are connected to the connectors or fasteners instead of the springs 21. Then, the springs 21 are connected to the removable adaptors 31 instead of directly to the device body. Specifically, the springs 21 are connected to the removable adaptors at the second positions 35 spaced apart from the first positions 33 relative to the device body.

The removable adaptor 33 is plate shaped, and is arranged with a longitudinal axis of the removable adaptor 33 parallel to a main surface of the device body.

The removable adaptor 33 may comprise a first connection element for connecting the removable adaptor to the device body at the first position 33. For example, the device body may comprise a pin, and the first connection element may comprise an opening, hole or recess for receiving the pin.

The removable adaptor 33 may comprise a second connection element for spring 21 at the second position 35. For example, the second connecting element may comprise a pin to which the spring 21 can be attached.

Therefore, by connecting the springs 21 indirectly to the device body via the removable adaptors 31, a length of the springs 21 is reduced relative to the length if the springs 21 were directly connected to the device body.

Including the removable adaptors 31 therefore reduces a length of the springs 21, and therefore reduces a biasing force applied to the ring gear 19 by the springs 21.

Therefore, when the springs 21 urge the ring gear 19 to rotate to cause the rotatable gripping pin assemblies 15 to grip the peripheral edge of the wafer W, the biasing force applied to the ring gear 19 is reduced, and therefore a force applied to the wafer W by the gripping pin assemblies 15 when they first contact the wafer W is reduced. This may prevent or reduce damage caused to the wafer, particularly when the wafer is a thin wafer.

Of course, in other embodiments a different type of resilient member may be used instead of the springs 21. For example, an elastic strip or rod could be used instead of the spring 21.

In addition, or alternatively, a number and or arrangement of the springs 21 may be different to that illustrated in FIG. 7. For example, one or more of the springs 21 may be provided, and/or the springs may be connected to different parts of the ring gear 19.

In addition, or alternatively, the shape and/or configuration of the ring gear 19 may be different to that illustrated in FIG. 19. For example, the ring gear 19 may have more or fewer spokes, or may not have spokes.

In addition, or alternatively, the damper 23 may be omitted, or more than one damper 23 may be provided.

While the invention has been described in conjunction with the exemplary embodiments described above, the scope of the invention is only defined by the appended claims.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.

## Claims

1. A device (25) for holding a wafer-shaped article, the device (25) having a device body comprising:
a surface (3) configured to face a wafer-shaped article supported by the device (25), the surface (3) having a central recessed portion (13);
first gas nozzles (5) having outlets (7) in the surface (3) outside the central recessed portion (13); and
second gas nozzles (27a, 27b) having outlets (29a, 29b) in the surface (3) inside the central recessed portion (13),
**characterised in that** each of the second gas nozzles (27a, 27b) is perpendicular to the surface (3), or substantially perpendicular to the surface (3).

2. The device (25) according to claim 1, wherein each of the first gas nozzles (5) is angled outwards relative to the perpendicular to the surface (3).

3. The device (25) according to claim 1 or claim 2, wherein the device (25) comprises a transparent window in the recessed portion (13), and the second gas nozzles (27a, 27b) include one or more gas nozzles (27b) in the transparent window.

4. The device (25) according to any one of the previous claims, wherein the device (25) includes a gas distribution chamber (9) in the device body, the gas distribution chamber (9) being connected to the first gas nozzles (5) and the second gas nozzles (27a, 27b).

5. The device (25) according to any one of the previous claims, where a number of the first gas nozzles (5) is greater than a number of the second gas nozzles (27a, 27b).

6. The device (25) according to any one of the previous claims, wherein the recessed portion (13) has a depth of 0.3 mm or more to 2 mm or less.

7. The device (25) according to any one of the previous claims, wherein the recessed portion (13) is circular and has a diameter of 210 mm or more to 250 mm or less.

8. The device (25) according to any one of the previous claims, wherein at least some of the outlets (7) of the first gas nozzles (5) are arranged in a circular pattern.

9. The device (25) according to any one of the previous claims, wherein at least some of the outlets (29a) of the second gas nozzles (27a) are arranged in a circular pattern.

10. The device (25) according to any one of the previous claims, wherein the device (25) comprises a plurality of gripping pin assemblies (15) adapted and positioned relative to the device body for gripping the wafer-shaped article, wherein each of the gripping pin assemblies (15) is rotatable between a gripping configuration in which the gripping pin assemblies (15) grip the wafer-shaped article, and a non-gripping configuration in which the gripping pin assemblies (15) do not grip the wafer-shaped article.

11. The device (25) according to claim 10, wherein the gripping pin assemblies (15) extend through the surface (3) outside the recessed portion (13), and the outlets (7) of the first gas nozzles (5) are located on the surface (3) between the gripping pin assemblies (15) and the recessed portion (13).

## Patentansprüche

1. Vorrichtung (25) zum Halten eines Wafer-förmigen Artikels, wobei die Vorrichtung (25) einen Vorrichtungskörper aufweist, der Folgendes umfasst:
eine Fläche (3), die ausgelegt ist, um einem Wafer-förmigen Artikel, der durch die Vorrichtung (25) getragen wird, zugewandt zu sein, wobei die Fläche (3) einen mittigen vertieften Abschnitt (13) aufweist;
erste Gasdüsen (5), die Auslässe (7) in der Fläche (3) außerhalb des mittigen vertieften Abschnitts (13) aufweisen; und
zweite Gasdüsen (27a, 27b), die Auslässe (29a, 29b) in der Fläche (3) innerhalb des mittigen vertieften Abschnitts (13) aufweisen,
**dadurch gekennzeichnet, dass** jede der zweiten Gasdüsen (27a, 27b) normal auf die Fläche (3) oder im Wesentlichen normal auf die Fläche (3) steht.

2. Vorrichtung (25) nach Anspruch 1, wobei jede der ersten Gasdüsen (5) relativ zu der Normalen auf die Fläche (3) nach außen angewinkelt ist.

3. Vorrichtung (25) nach Anspruch 1 oder Anspruch 2, wobei die Vorrichtung (25) ein transparentes Fenster in dem vertieften Abschnitt (13) umfasst, und die zweiten Gasdüsen (27a, 27b) eine oder mehrere Gasdüsen (27b) in dem transparenten Fenster umfassen.

4. Vorrichtung (25) nach einem der vorangegangenen Ansprüche, wobei die Vorrichtung (25) eine Gasverteilungskammer (9) in dem Vorrichtungskörper umfasst, wobei die Gasverteilungskammer (9) mit den ersten Gasdüsen (5) und den zweiten Gasdüsen (27a, 27b) verbunden ist.

5. Vorrichtung (25) nach einem der vorangegangenen Ansprüche, wobei eine Anzahl der ersten Gasdüsen (5) größer ist als eine Anzahl der zweiten Gasdüsen (27a, 27b).

6. Vorrichtung (25) nach einem der vorangegangenen Ansprüche, wobei der vertiefte Abschnitt (13) eine Tiefe von 0,3 mm oder mehr bis 2 mm oder weniger aufweist.

7. Vorrichtung (25) nach einem der vorangegangenen Ansprüche, wobei der vertiefte Abschnitt (13) kreisförmig ist und einen Durchmesser von 210 mm oder mehr bis 250 mm oder weniger aufweist.

8. Vorrichtung (25) nach einem der vorangegangenen Ansprüche, wobei zumindest manche der Auslässe (7) der ersten Gasdüsen (5) in einem kreisförmigen Muster angeordnet sind.

9. Vorrichtung (25) nach einem der vorangegangenen Ansprüche, wobei zumindest manche der Auslässe (29a) der zweiten Gasdüsen (27a) in einem kreisförmigen Muster angeordnet sind.

10. Vorrichtung (25) nach einem der vorangegangenen Ansprüche, wobei die Vorrichtung (25) eine Vielzahl von Greifstiftanordnungen (15) umfasst, die ausgelegt und relativ zu dem Vorrichtungskörper positioniert sind, um den Wafer-förmigen Artikel zu greifen, wobei jede der Greifstiftanordnungen (15) zwischen einer greifenden Konfiguration, in der die Greifstiftanordnungen (15) den Wafer-förmigen Artikel greifen, und einer nichtgreifenden Konfiguration, in der die Greifstiftanordnungen (15) den Wafer-förmigen Artikel nicht greifen, drehbar ist.

11. Vorrichtung (25) nach Anspruch 10, wobei sich die Greifstiftanordnungen (15) durch die Fläche (3) außerhalb des vertieften Abschnitts (13) erstrecken, und wobei die Auslässe (7) der ersten Gasdüsen (5) auf der Fläche (3) zwischen den Greifstiftanordnungen (15) und dem vertieften Abschnitt (13) angeordnet sind.

## Revendications

1. Dispositif (25) de maintien d'un article en forme de tranche, le dispositif (25) présentant un corps de dispositif comprenant :
une surface (3) configurée pour faire face à un article en forme de tranche supporté par le dispositif (25), la surface (3) présentant une partie évidée centrale (13) ;
des premières buses de gaz (5) présentant des sorties (7) dans la surface (3) à l'extérieur de la partie évidée centrale (13) ; et
des secondes buses de gaz (27a, 27b) présentant des sorties (29a, 29b) dans la surface (3) à l'intérieur de la partie évidée centrale (13),
**caractérisé en ce que** chacune des secondes buses de gaz (27a, 27b) est perpendiculaire à la surface (3), ou sensiblement perpendiculaire à la surface (3).

2. Dispositif (25) selon la revendication 1, dans lequel chacune des premières buses de gaz (5) est inclinée vers l'extérieur par rapport à la perpendiculaire à la surface (3).

3. Dispositif (25) selon la revendication 1 ou la revendication 2, dans lequel le dispositif (25) comprend une fenêtre transparente dans la partie évidée (13), et les secondes buses de gaz (27a, 27b) incluent une ou plusieurs buses de gaz (27b) dans la fenêtre transparente.

4. Dispositif (25) selon l'une quelconque des revendications précédentes, dans lequel le dispositif (25) inclut une chambre de distribution de gaz (9) dans le corps de dispositif, la chambre de distribution de gaz (9) étant connectée aux premières buses de gaz (5) et aux secondes buses de gaz (27a, 27b).

5. Dispositif (25) selon l'une quelconque des revendications précédentes, dans lequel un nombre des premières buses de gaz (5) est supérieur à un nombre des secondes buses de gaz (27a, 27b).

6. Dispositif (25) selon l'une quelconque des revendications précédentes, dans lequel la partie évidée (13) présente une profondeur de 0,3 mm ou plus à 2 mm ou moins.

7. Dispositif (25) selon l'une quelconque des revendications précédentes, dans lequel la partie évidée (13) est circulaire et présente un diamètre de 210 mm ou plus à 250 mm ou moins.

8. Dispositif (25) selon l'une quelconque des revendications précédentes, dans lequel au moins certaines des sorties (7) des premières buses de gaz (5) sont agencées selon un motif circulaire.

9. Dispositif (25) selon l'une quelconque des revendications précédentes, dans lequel au moins certaines des sorties (29a) des secondes buses de gaz (27a) sont agencées selon un motif circulaire.

10. Dispositif (25) selon l'une quelconque des revendications précédentes, dans lequel le dispositif (25) comprend une pluralité d'ensembles de broche de préhension (15) adaptés et positionnés par rapport au corps de dispositif pour saisir l'article en forme de tranche, dans lequel chacun des ensembles de broche de préhension (15) peut tourner entre une configuration de préhension dans laquelle les ensembles de broche de préhension (15) saisissent l'article en forme de tranche, et une configuration de non préhension dans laquelle les ensembles de broche de préhension (15) ne saisissent pas l'article en forme de tranche.

11. Dispositif (25) selon la revendication 10, dans lequel les ensembles de broche de préhension (15) s'étendent à travers la surface (3) à l'extérieur de la partie évidée (13), et les sorties (7) des premières buses de gaz (5) sont situées sur la surface (3) entre les ensembles de broche de préhension (15) et la partie évidée (13).
